# EUROPEAN PATENT APPLICATION

(11) **EP 2 490 356 A1**
(43) Date of publication of application: **22.08.2012**
(21) Application number: 12155810.0
(22) Date of filing: 16.02.2012
(51) Int. Cl.: H04H 60/11, H03M 13/15, H04N 7/68

(54) **Multiplex broadcasting receiver**

(30) Priority: 18.02.2011 JP 2011033418
(71) Applicant: Alpine Electronics, Inc., Tokyo (JP)
(72) Inventor: Chiba, Masatoshi, Iwaki-city, Fukushima (JP)
(74) Representative: Klunker . Schmitt-Nilson . Hirsch

(57) **Abstract**

A multiplex broadcasting receiver (100) includes a Viterbi decoder (24) for performing Viterbi decoding processing, an input buffer (32) for storing received data, an RS decoder (34) for reading out the received data stored in the input buffer (32), performing Reed-Solomon decoding processing on the received data, and storing the received data in the output buffer (36), as well as for associating the number of corrections with a PID value and outputting them, a demultiplexer (38) for separating receiving target data from the received data stored in the output buffer (36), a video decoder (42), an audio decoder (46), and a data service decoder (50) for performing decoding processing on the separated data, and a main control section (60) for transmitting an output control instruction to, for example, the video decoder (42) on the basis of the number of error corrections corresponding to each PID value.

## Description

The present invention relates to a multiplex broadcasting receiver for receiving broadcasting data in which a plurality of programs are multiplexed and reproducing the broadcasting data.

Multiplex broadcasting receivers for receiving data that complies with the MPEG2-TS (Transport Stream) standard are known (see, for example, pages 5 to 13 and Figs. 1 to 15 in JP 2008-206156 A). Such a broadcasting receiver sometimes performs two types of error detection/correction processing on received data. One of these types of error detection/correction processing is Viterbi decoding processing for convolutional coding, and the other type is Reed-Solomon decoding processing for Reed-Solomon coding. In particular, an error correction capability in the Reed-Solomon decoding processing is high. Accordingly, even if errors are included in received data, error correction can be performed in a wide range and a good-quality audio output and a good-quality video output can be obtained.

However, when a reception condition becomes worse, error correction performed in the Reed-Solomon decoding processing may be inadequate, sound quality and image quality may be deteriorated, and a viewer may experience an uncomfortable feeling. Various receivers for muting an output in such a case to reduce an uncomfortable feeling experienced by a viewer are known (see, for example, pages 5 to 9 and Figs. 1 to 14 in JP 10-028065 A, pages 2 to 4 and Fig. 1 in JP 2002-354359 A, and pages 4 to 6 and Figs. 1 to 3 in JP 2000-221996 A).

In the case of received data that complies with the MPEG2-TS standard, which is disclosed in, for example, JP 2008-206156 A, a plurality of pieces of multiplexed program data included in the received data are separated and audio data and video data of each program are obtained. All of pieces of audio data and all of pieces of video data do not include an error-detecting code, and it is impossible to individually check quality of these pieces of audio data and these pieces of video data. Accordingly, processing for controlling an output for each program in accordance with reception quality (for example, mute processing in the case of audio data) cannot be performed.

It may be an object of the present invention to provide a multiplex broadcasting receiver capable of controlling an output for each of a plurality of multiplexed programs in accordance with reception quality.

The problem is solved by the features of the independent claims. Further embodiments and developments are defined in the respective dependent claims.

A multiplex broadcasting receiver according to an embodiment of the present invention has a configuration complying with the MPEG2-TS standard and is configured to receive data in which a plurality of pieces of program data are multiplexed. The multiplex broadcasting receiver includes: Viterbi decoding processing means configured to perform Viterbi decoding processing on received data; first data storing means configured to store the received data output from the Viterbi decoding processing means;, second data storing means; Reed-Solomon decoding processing means configured to read out the received data stored in the first data storing means, to perform Reed-Solomon decoding processing on the received data, and to store the received data in the second data storing means, and as well as to associate error information obtained when performing error correction in the Reed-Solomon decoding processing with packet identification information of a transport packet that complies with the MPEG2-TS standard and to output the error information and the packet identification information; data separating means configured to separate receiving target program data, which is one of the plurality of pieces of program data, from the received data stored in the second data storing means; decoding means configured to perform decoding processing on the program data separated by the data separating means and output one, some, or all of a video signal, an audio signal, and a data service signal as a decoding output signal; and output controlling means configured to transmit an instruction for controlling an output of the decoding means to the decoding means on the basis of the error information associated with the packet identification information.

In the configuration that complies with the MPEG2-TS standard, transport packets included in a program are individually associated with different pieces of packet identification information. Accordingly, by using pieces of error information that are obtained in Reed-Solomon decoding processing and that correspond to these pieces of packet identification information, it is possible to perform output control for each of a plurality of multiplexed programs in accordance with reception quality.

In a further development, the second data storing means may comprise at least two areas. When the Reed-Solomon decoding processing means uses one of the areas for writing, received data may be read out from another one of the areas and input into the decoding means. Thus, the output controlling means may preferably control the output of the decoding means on the basis of the error information corresponding to the received data read out from the another one of the areas. In a certain embodiment the second data storing comprises two areas. By having two (or more) areas the second data storing means has two (or more) planes, thus error information can be obtained in each of the planes. As a result, output control can be easily performed.

Additionally, the output controlling means may preferably control the output of the decoding means on the basis of the error information obtained for each piece of packet identification information. As a result, reception quality can be determined in a certain period and output control can be performed on the basis of a result of the determination. It is therefore possible to prevent a user from experiencing an uncomfortable feeling owing to frequently changed output control.

The error information may be the number of error corrections. When the number of error corrections exceeds a predetermined reference value, the output controlling means can perform output control of a signal corresponding to a Packetized Elementary Stream (PES) specified by the packet identification information corresponding to the number of error corrections. When the number of error corrections exceeds the predetermined reference value, it can be considered that error correction is adequately performed at this time. However, from this point onward, it can be considered that reception quality will be reduced and error correction will not keep up with an increasing number of errors (conversely, the reference is determined in consideration of such a case). By controlling the output of the decoding means in such a case, it is possible to prevent the occurrence of sound skipping in an audio output and the occurrence of serious image degradation in a video output in advance.

Alternatively, the error information may be the number of error corrections and the number of errors before the error correction. When there is an error that has not been corrected in the error correction, the output controlling means preferably performs output control of a signal corresponding to a PES specified by the packet identification information corresponding to the error information. By controlling the output of the decoding means when error correction is inadequately performed and there is an uncorrected error, it is possible to prevent the occurrence of sound skipping in an audio output and the occurrence of serious image degradation in a video output with certainty.

Accordingly, when a signal output from the decoding means is an audio signal, the output controlling means can transmit to the decoding means a mute instruction for stopping the audio signal from outputting. As a result, it is possible to prevent a user from experiencing an uncomfortable feeling owing to serious degradation in audio output quality in advance.

Accordingly, when a signal output from the decoding means is a video signal, the output controlling means can transmit to the decoding means a fade-out instruction for gradually darkening a screen image corresponding to the video signal. As a result, it is possible to prevent a user from experiencing an uncomfortable feeling owing to serious degradation in video display quality in advance.

### BRIEF DESCRIPTION OF THE DRAWINGS

Fig. 1 is a diagram illustrating a basic MPEG2-TS data structure;
Fig. 2 is a diagram illustrating a data structure of a PAT;
Fig. 3 is a diagram illustrating a data structure of a PMT;
Fig. 4 is a diagram illustrating a concrete example of the schematic relationship among a PAT, a PMT, and PESs;
Fig. 5 is a diagram illustrating a configuration of a multiplex broadcasting receiver according to an embodiment;
Fig. 6 is a diagram describing the number of RS error corrections output from an RS decoder and counted by a main control section;
Figs. 7A and 7B are diagrams describing a process from the output of the number of RS error corrections to the transmission of an output control instruction to a video decoder and an audio decoder; and
Figs. 8C and 8D are diagrams describing the process from the output of the number of RS error corrections to the transmission of an output control instruction to a video decoder and an audio decoder.

### DESCRIPTION OF THE PREFERRED EMBODIMENTS

A multiplex broadcasting receiver according to an embodiment of the present invention will be described below with reference to the accompanying drawings.

### (MPEG2-TS Data Structure)

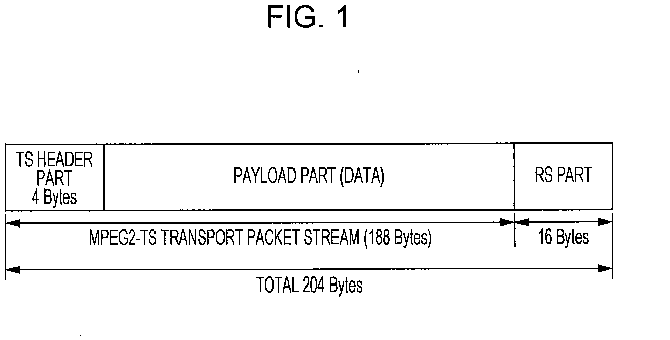

First, an MPEG2-TS data structure will be described. Fig. 1 is a diagram illustrating a basic MPEG2-TS data structure. As illustrated in Fig. 1, an MPEG2 TS includes a TS header part, a payload part (data), and an RS part. The TS header part and the payload part form a 188-byte transport packet. The RS part is a Reed-Solomon parity word, and is used to correct an error in a transport packet. In a transport stream (TS), transport packets each having a fixed length of 188 bytes are multiplexed or separated.

Pieces of data transmitted in the form of an MPEG2 TS include a Program Association Table (PAT), a Program Map Table (PMT), a Conditional Access Table (CAT), a Network Information Table (NIT), and various Packetized Elementary Streams (PESs).

A PAT describes Packet IDentification information (PIDs) of transport packets that transmit tables (PMTs) describing the structures of programs represented by program numbers. The PID of the PAT is a fixed value (0x0000). This PAT is received once within a predetermined time.

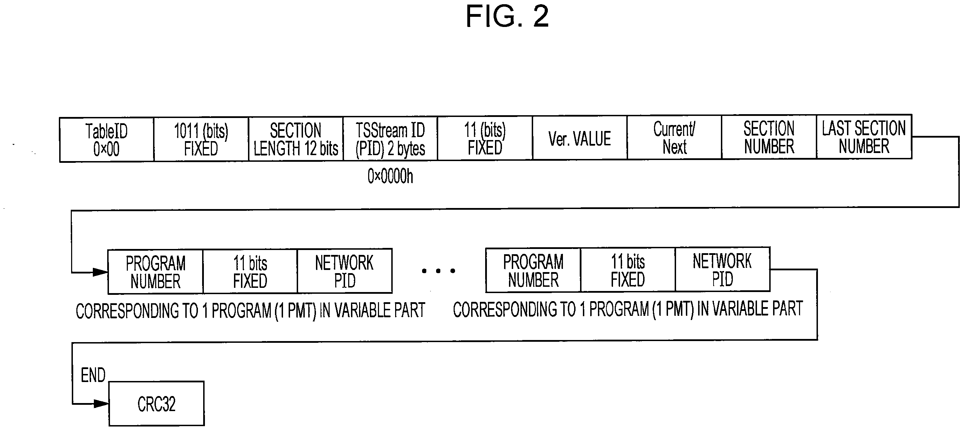

Fig. 2 is a diagram illustrating a data structure of a PAT. As illustrated in Fig. 2, a PAT includes a network ID (PID) of each PMT and a Cyclic Redundancy Check (CRC) 32 that is an error-detecting code at the end.

A PMT describes, in the payload part of a transport packet thereof, a list of PIDs of transport packets that transmit streams corresponding to video data and audio data included in a single program and additional information.

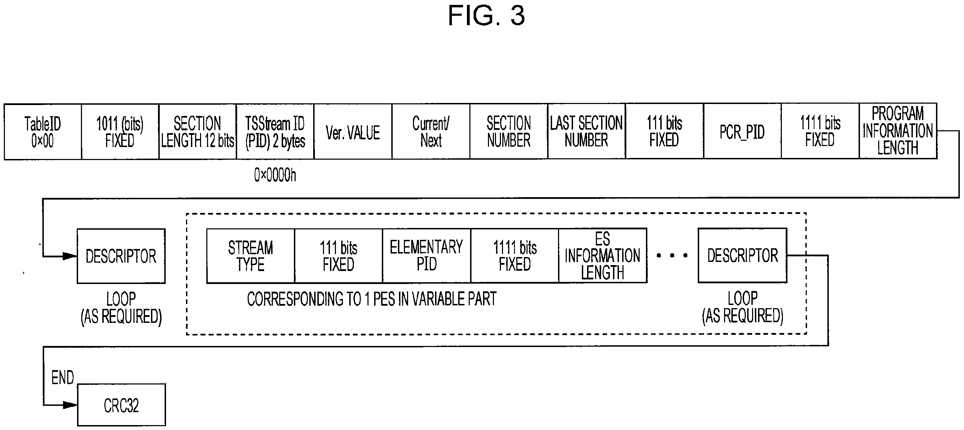

Fig. 3 is a diagram illustrating a data structure of a PMT. In the drawing, stream type represents the type (for example, audio or video) of a PES, elementary PID represents the PID of the PES, and ES information length represents the byte length of a descriptor subsequent thereto. The PMT includes a CRC32 at the end.

A CAT describes, in the payload part of a transport packet thereof, information about Conditional Access (CA) to a program (scramble information). A PID including actual interpretation/decoding approval information can be obtained from this CAT, and unscrambling information can be obtained.

An NIT describes, in the payload part of a transport packet thereof, broadcasting station network information of a program.

Various PESs each store packetized audio, video, or service data. PES stands for Packetized Elementary Stream. An elementary stream is a coded video, audio, or data service.

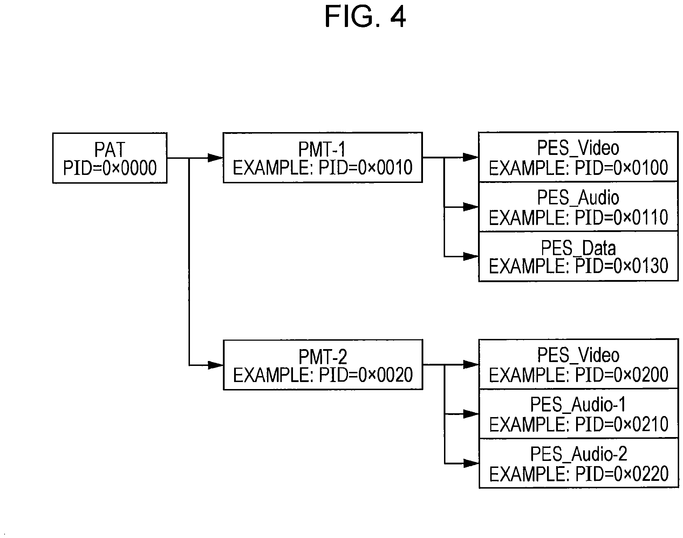

Fig. 4 is a diagram illustrating a concrete example of the schematic relationship among a PAT, a PMT, and PESs. In the example illustrated in Fig. 4, the PMTs (PMT-1 and PMT-2) of two programs are specified from a PAT. From the PMT-1, a single PES for video, a single PES for audio, and a single PES for data are specified. From the PMT-2, a single PES for video and two PESs for audio are specified.

When program data of two programs is received, error correction is performed on the program data by Viterbi decoding processing and Reed-Solomon decoding processing to obtain correct received data. Subsequently, one of the programs included in the received data is separated and various PESs are decoded. As a result, a video signal and an audio signal are obtained.

### (Configuration of Multiplex Broadcasting Receiver)

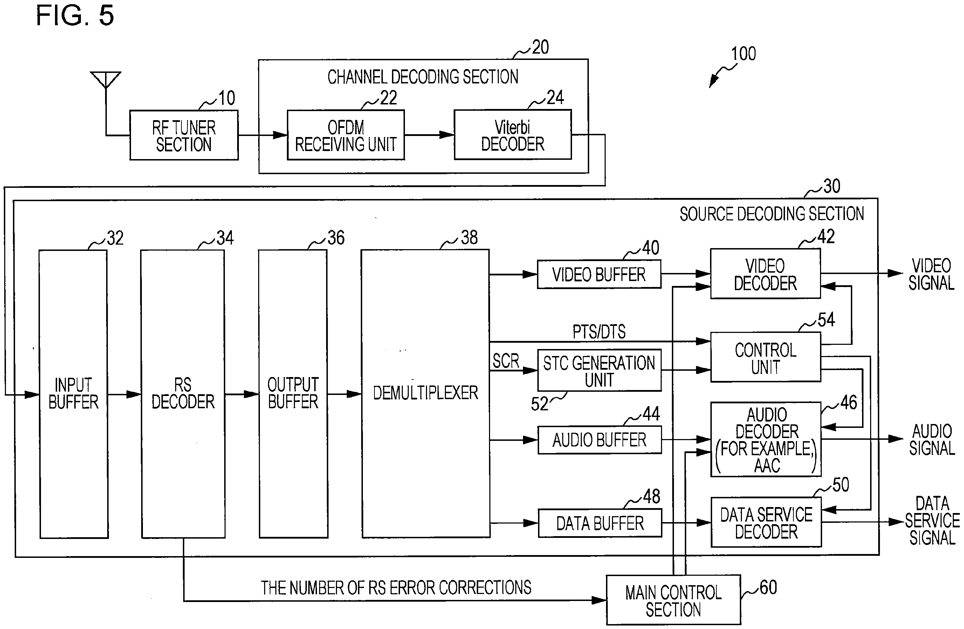

Next, the configuration of a multiplex broadcasting receiver according to an embodiment will be described. Fig. 5 is a diagram illustrating a configuration of a multiplex broadcasting receiver 100 according to an embodiment. As illustrated in Fig. 5, the multiplex broadcasting receiver 100 includes an RF tuner section 10, a channel decoding section 20, a source decoding section 30, and a main control section 60. For example, the multiplex broadcasting receiver 100 receives broadcast data multiplexed with the Digital Multimedia Broadcasting (DMB) method.

The RF tuner section 10 extracts a desired receiving frequency (tuning frequency) component from a signal received via an antenna, performs frequency conversion on the extracted frequency component, and outputs an intermediate frequency signal.

The channel decoding section 20 is a front-end portion, and includes an Orthogonal Frequency Division Multiplex (OFDM) receiving unit 22 and a Viterbi decoder 24. The OFDM receiving unit 22 removes a guard interval from a received OFDM symbol and performs a predetermined demodulation operation by performing fast Fourier transform on the OFDM symbol. The Viterbi decoder 24 performs error correction by performing Viterbi decoding processing on a signal demodulated by the OFDM receiving unit 22 and outputs error-corrected received data.

The source decoding section 30 is a back-end portion, and includes an input buffer 32, a Reed-Solomon (RS) decoder 34, an output buffer 36, a demultiplexer 38, a video buffer 40, a video decoder 42, an audio buffer 44, an audio decoder 46, a data buffer 48, a data service decoder 50, a System Time Clock (STC) generation unit 52, and a control unit 54.

The input buffer 32 stores the received data output from the Viterbi decoder 24 in the channel decoding section 20. The RS decoder 34 reads out the received data stored in the input buffer 32 in units of transport packets, and performs error correction by performing Reed-Solomon decoding processing on the transport packets. The error-corrected transport packets are stored in the output buffer 36 in a predetermined order (for example, based on a PID value). Furthermore, the RS decoder 34 outputs the number of RS error corrections (the number of error corrections) as error information along with a PID value to the main control section 60 when performing Reed-Solomon decoding processing on each of the transport packets. The demultiplexer 38 separates transport packets having PID values corresponding to a program to be received from a stream read out from the output buffer 36, and outputs the transport packets.

The video buffer 40 temporarily stores packetized video data in a PES. The video decoder 42 reads out the video data stored in the video buffer 40, performs predetermined demodulation processing (for example, processing defined by Recommendation H.246) on the video data, and outputs a video signal. The audio buffer 44 temporarily stores packetized audio data in a PES. The audio decoder 46 reads out the audio data stored in the audio buffer 44, performs predetermined demodulation processing (for example, Advanced Audio Coding (AAC)) on the audio data, and outputs an audio signal. The data buffer 48 temporarily stores packetized data for data service in a PES. The data service decoder 50 reads out the data stored in the data service decoder 50 and performs predetermined demodulation processing on the data.

The STC generation unit 52 outputs an STC that is a time standard on the basis of a System Clock Reference (SCR) included in a transport stream. The control unit 54 controls the video decoder 42, the audio decoder 46, and the data service decoder 50 on the basis of a Presentation Time Stamp (PTS) and a Decoding Time Stamp (DTS) which are included in a transport packet and the STC output from the STC generation unit 52. The main control section 60 performs overall control of the multiplex broadcasting receiver 100. In addition, the main control section 60 counts the number of RS error corrections corresponding to each PID value output from the RS decoder 34 and transmits an output control instruction to the video decoder 42 and the audio decoder 46 as needed on the basis of a result of the counting.

The Viterbi decoder 24 corresponds to Viterbi decoding processing means, the input buffer 32 corresponds to first data storing means, the output buffer 36 corresponds to second data storing means, the RS decoder 34 corresponds to Reed-Solomon decoding processing means, the demultiplexer 38 corresponds to data separating means, the video decoder 42, the audio decoder 46, and the data service decoder 50 correspond to decoding means, and the main control section 60 corresponds to output controlling means.

The multiplex broadcasting receiver 100 according to this embodiment has the above-described configuration. Next, an operation of controlling an audio output and a video output on the basis of the number of RS error corrections output from the RS decoder 34 will be described.

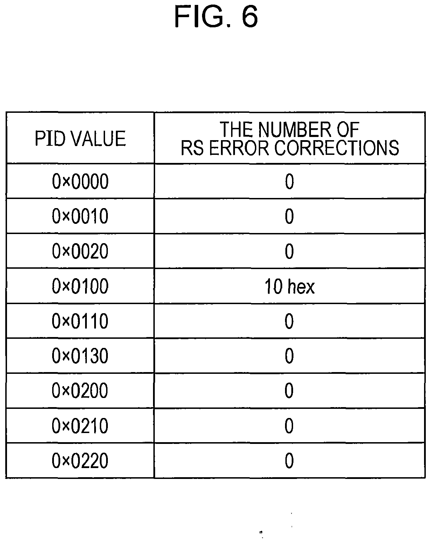

Fig. 6 is a diagram describing the number of RS error corrections output from the RS decoder 34 and counted by the main control section 60, and illustrates an example of the number of RS error corrections in the case of the program structure illustrated in Fig. 4. When the number of RS error corrections corresponding to each PES is obtained, output control can be performed on a corresponding signal in accordance with the type (audio or video) of the PES. The main control section 60 counts the number of RS error corrections output from the RS decoder 34 for each PID value, and creates a summary table (a table describing the number of RS error corrections) illustrated in Fig. 6. As a counting method, a method of accumulating RS error corrections corresponding to each PID, a method of calculating an average value, or a method of extracting the maximum value is considered.

The table illustrated in Fig. 6 includes the numbers of RS error corrections corresponding to all transport packets illustrated in Fig. 4. However, since the numbers of RS error corrections corresponding to a PAT and PMTs are not used for output control, they may be removed from the table.

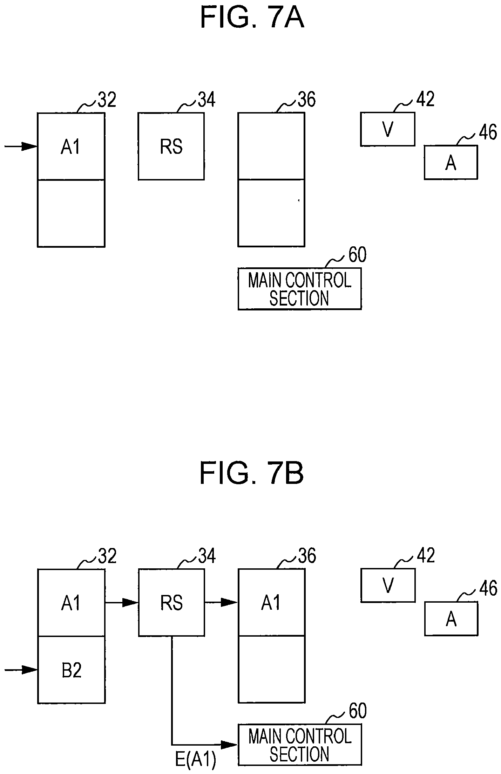

Figs. 7A to 8D are diagrams describing a process from the output of the number of RS error corrections to the transmission of an output control instruction to the video decoder 42 and the audio decoder 46. In this embodiment, each of the input buffer 32 and the output buffer 36 has two planes (areas A and B). While received data is written into one of these planes (areas), the received data can be read out from the other one of these planes (areas).

In Figs. 7A to 8D, it is assumed that a plurality of transport packets having a predetermined volume input/output into/from the input buffer 32 and the output buffer 36 are defined as A1, B2, A3, B4, in the order of input. Pieces of received data A1 and A3 are input/output using the area A, and pieces of received data B2 and B4 are input/output using the area B. A numeric character added to A or B represents the order of input of a transport packet E(A1) represents the number of RS error corrections output when the RS decoder 34 reads out received data represented by A1 from the area A in the input buffer 32 and performs Reed-Solomon decoding processing on the received data. S(A1) represents an output control signal transmitted from the main control section 60 to the video decoder 42 and the audio decoder 46 when the video decoder 42 and the audio decoder 46 perform video demodulation processing and audio demodulation processing, respectively, on the received data (PES) represented by A1 read out from the area A in the output buffer 36.

First, the received data A1 is written into the area A in the input buffer 32 (Fig. 7A). This writing operation is continued until the area A is full or the area A reaches a writing capacity determined in advance,

Subsequently, an area in the input buffer 32 into which received data is written is changed from the area A to the area B (Fig. 7B). The received data B2 is written into the area B in the input buffer 32. In parallel with this writing operation, the RS decoder 34 reads out the received data A1 from the area A in the input buffer 32 in units of transport packets illustrated in Fig. 1, performs Reed-Solomon decoding processing on the read received data A1, and writes the error-corrected received data A1 into the area A in the output buffer 36. Furthermore, the numbers of RS error corrections E(A1) corresponding to the transport packets in the received data A1 are output from the RS decoder 34 along with PID values, are input into the main control section 60, and are counted by the main control section 60.

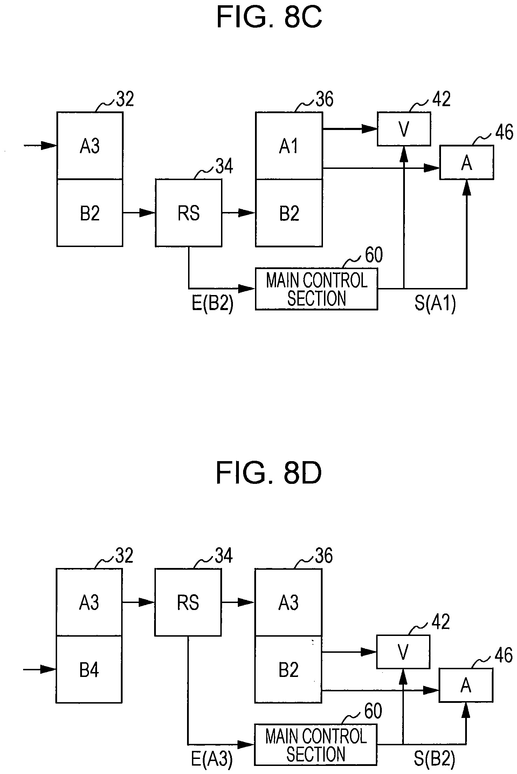

Subsequently, the area in the input buffer 32 into which received data is written is changed from the area B to the area A (Fig. 8C). The received data A3 is written in the area A in the input buffer 32. In parallel with this writing operation, the RS decoder 34 reads out the received data B2 from the area B in the input buffer 32 in units of transport packets illustrated in Fig. 1, performs Reed-Solomon decoding processing on the read received data B2, and writes the error-corrected received data B2 into the area B in the output buffer 36. Furthermore, the numbers of RS error corrections E(B2) corresponding to the transport packets in the received data B2 are output from the RS decoder 34 along with PID values, are input into the main control section 60, and are counted by the main control section 60. In parallel with these operations, the demultiplexer 38 separates PESs corresponding to a program that a user wishes to receive from the error corrected received data A1 written in the area A in the output buffer 36 and inputs the separated PESs into the video decoder 42 and the audio decoder 46 (since output control performed on these decoders is focused on, the description of data service will be omitted). The main control section 60 reads out an aggregate value of the number of RS error corrections corresponding to a PID value of each PES input into the video decoder 42 and the audio decoder 46 from the table describing the number of RS error corrections. When the aggregate value exceeds a predetermined reference value, the main control section 60 inputs a control signal S(A1) for limiting an output into the video decoder 42 and the audio decoder 46 into which the PESs having the PID values have been input.

The larger the number of RS error corrections, the worse the transmission state of a broadcast wave. When the number of RS error corrections exceeds the predetermined reference value, it is probable that sound skipping will occur in the audio case and an image is distorted in the video case. Accordingly, when the number of RS error corrections counted for each PID value exceeds a predetermined reference value set for the PID value, the video decoder 42 and the audio decoder 46 perform fade-out processing (processing for gradually darkening a screen image) and mute processing (processing for making sound disappear completely), respectively, on the basis of the control signal S(A1) output from the main control section 60. The determination of whether the video decoder 42 and the audio decoder 46 perform the fade-out processing and the mute processing, respectively, is made for each PID value corresponding to a PES. Accordingly, only one of these pieces of processing may be performed. When only one of the fade-out processing and the mute processing is performed, the other one of them also may be performed.

Subsequently, the area in the input buffer 32 into which received data is written is changed from the area A to the area B (Fig. 8D). The received data B4 is written in the area B in the input buffer 32. In parallel with this writing operation, the RS decoder 34 reads out the received data A3 from the area A in the input buffer 32 in units of transport packets illustrated in Fig. 1, performs Reed-Solomon decoding processing on the read received data A3, and writes the error-corrected received data A3 into the area A in the output buffer 36. Furthermore, the numbers of RS error corrections E(A3) corresponding to the transport packets in the received data A3 are output from the RS decoder 34 along with PID values, are input into the main control section 60, and are counted by the main control section 60. In parallel with these operations, the demultiplexer 38 separates PESs corresponding to a program that a user wishes to receive from the error corrected received data B2 written in the area B in the output buffer 36 and inputs the separated PESs into the video decoder 42 and the audio decoder 46. The main control section 60 reads out an aggregate value of the number of RS error corrections corresponding to a PID value of each PES input into the video decoder 42 and the audio decoder 46 from the table describing the number of RS error corrections. When the aggregate value exceeds a predetermined reference value, the main control section 60 inputs a control signal S(B2) for limiting an output into the video decoder 42 and the audio decoder 46 into which the PESs having the PID values have been input. Thus, on the basis of the control signal S(B2) output from the main control section 60, the video decoder 42 and the audio decoder 46 perform the fade-out processing and the mute processing, respectively.

Thus, in the multiplex broadcasting receiver 100 according to this embodiment, the number of error corrections (the number of RS error corrections) obtained at the time of Reed-Solomon decoding processing is associated with a PID value, is output from the RS decoder 34, and is counted by the main control section 60. It is therefore possible to perform output control for each of a plurality of multiplexed programs in accordance with reception quality. Since the input buffer 32 and the output buffer 36 have two planes (areas), the acquirement and counting of the number of RS error corrections can be easily performed in each of these planes. As a result, output control can be easily performed.

Using a result of counting of the number of RS error corrections obtained for each PID value, reception quality can be determined in a certain period (counting period) and output control can be performed in accordance with a result of the determination. It is therefore possible to prevent a user from experiencing an uncomfortable feeling owing to frequently changed output control.

Furthermore, by controlling the output of the video decoder 42 when the number of RS error corrections exceeds a predetermined reference value, it is possible to prevent a user from experiencing an uncomfortable feeling owing to serious degradation in video display quality or video image quality in advance. Correspondingly, by controlling the output of the audio decoder 46 when the number of RS error corrections exceeds a predetermined reference value, it is possible to prevent a user from experiencing an uncomfortable feeling owing to serious degradation in audio output quality in advance.

The present invention is not limited to the above-described embodiment, and various changes or additions can be made thereto without departing from the present invention as defined in the appending claims. For example, in the above-described embodiment, the number of RS error corrections corresponding to each PID value is output from the RS decoder 34 as error information and is counted. However, alternatively or additionally another piece of error information may be used.

For example, it is assumed that the error information output from the RS decoder 34 includes, in addition to the number of RS error corrections, the number of RS errors that is the number of errors before error correction. The main control section 60, on the basis of the number of RS error corrections and the number of RS errors corresponding to each PID value which are output from the RS decoder 34, counts the number of remaining RS errors, that is, the number of uncorrected RS errors, corresponding to the PID value and instructs the video decoder 42 and the audio decoder 46 to control output on the basis of a result of the counting For example, when there is one remaining uncorrected RS error (the number of RS errors > the number of RS error corrections), the outputs of the video decoder 42 and the audio decoder 46 are controlled. The main control section 60 performs output control in the operation sequence illustrated in Figs. 7A to 8D. In this case, not only the number of RS error corrections E corresponding to each transport packet but also the number of RS errors E' are output from the RS decoder 34 along with a PID value and are input into the main control section 60. The main control section 60 counts the number of uncorrected RS errors for each PID value.

Thus, by controlling the outputs of the video decoder 42 and the audio decoder 46 when error correction is inadequately performed and a remaining uncorrected RS error is present, it is possible to prevent the occurrence of sound skipping in an audio output and the occurrence of serious image degradation in a video output with certainty.

As described previously, according to an embodiment of the present invention, it is possible to perform output control for each of a plurality of multiplexed programs in accordance with reception quality by associating the number of error corrections obtained in Reed-Solomon decoding processing (the number of RS error corrections) with a PID value, outputting the number of RS error corrections and the PID value from the RS decoder 34, and counting the number of RS error corrections.

## Claims

1. A multiplex broadcasting receiver having a configuration complying with the MPEG2-TS standard and being configured to receive data in which a plurality of pieces of program data are multiplexed, the receiver comprising:
Viterbi decoding processing means (24) configured to perform Viterbi decoding processing on the received data;
first data storing means (32) configured to store the received data output from the Viterbi decoding processing means;
second data storing means (36);
Reed-Solomon decoding processing means (34) configured to read out the received data stored in the first data storing means, to perform Reed-Solomon decoding processing on the received data, and to store the received data in the second data storing means, and as well as to associate error information obtained when performing error correction in the Reed-Solomon decoding processing with packet identification information of a transport packet that complies with the MPEG2-TS standard and to output the error information and the packet identification information;
data separating means (38) configured to separate receiving target program data, which is one of the plurality of pieces of program data, from the received data stored in the second data storing means;
decoding means (42, 46, 50) configured to perform decoding processing on the program data separated by the data separating means and output one, some, or all of a video signal, an audio signal, and a data service signal as a decoding output signal; and
output controlling means (60) configured to transmit an instruction for controlling an output of the decoding means to the decoding means on the basis of the error information associated with the packet identification information.

2. The multiplex broadcasting receiver according to Claim 1,
wherein the second data storing means has two areas, and when the Reed-Solomon decoding processing means uses one of the areas for writing, received data is read out from the other one of the areas and is input into the decoding means, and
wherein the output controlling means controls the output of the decoding means on the basis of the error information corresponding to the received data read out from the other one of the areas.

3. The multiplex broadcasting receiver according to Claim 2, wherein the output controlling means controls the output of the decoding means on the basis of the error information obtained for each piece of packet identification information.

4. The multiplex broadcasting receiver according to Claim 2 or 3,
wherein the error information is a number of error corrections, and wherein, when the number of error corrections exceeds a predetermined reference value, the output controlling means is configured to perform output control of a signal corresponding to a Packetized Elementary Stream (PES) specified by the packet identification information corresponding to the error information.

5. The multiplex broadcasting receiver according to Claim 2 or 3,
wherein the error information is a number of error corrections and a number of errors before the error correction, and
wherein, when there is an error that has not been corrected in the error correction, the output controlling means performs output control of a signal corresponding to a PES specified by the packet identification information corresponding to the error information.

6. The multiplex broadcasting receiver according to Claim 4 or 5, wherein, when a signal output from the decoding means is an audio signal, the output controlling means transmits to the decoding means a mute instruction for stopping the audio signal from outputting.

7. The multiplex broadcasting receiver according to Claim 4 or 5, wherein, when a signal output from the decoding means is a video signal, the output controlling means transmits to the decoding means a fade-out instruction for gradually darkening a screen image corresponding to the video signal.
